(19) Europäisches Patentamt / European Patent Office / Office européen des brevets

(11) **EP 3 140 906 B1**

(12) **FASCICULE DE BREVET EUROPEEN**

(45) Date de publication et mention
de la délivrance du brevet:
**02.12.2020 Bulletin 2020/49**

(51) Int Cl.:
*H03F 3/00* *(2006.01)*  *G01J 5/24* *(2006.01)*
*H03F 3/04* *(2006.01)*

(21) Numéro de dépôt: **15759830.1**

(22) Date de dépôt: **30.04.2015**

(86) Numéro de dépôt international:
**PCT/FR2015/051164**

(87) Numéro de publication internationale:
**WO 2015/170041 (12.11.2015 Gazette 2015/45)**

(54) **DISPOSITIF HAUTE DYNAMIQUE POUR L'INTEGRATION D'UN COURANT ELECTRIQUE**

VORRICHTUNG MIT HOHEM DYNAMIKUMFANG ZUR INTEGRATION EINES ELEKTRISCHEN STROMS

HIGH DYNAMIC RANGE DEVICE FOR INTEGRATING AN ELECTRICAL CURRENT

(84) Etats contractants désignés:
**AL AT BE BG CH CY CZ DE DK EE ES FI FR GB GR HR HU IE IS IT LI LT LU LV MC MK MT NL NO PL PT RO RS SE SI SK SM TR**

(30) Priorité: **07.05.2014 FR 1454119**

(43) Date de publication de la demande:
**15.03.2017 Bulletin 2017/11**

(73) Titulaire: **LYNRED**
**91120 Palaiseau (FR)**

(72) Inventeur: **ROBERT, Patrick**
**38140 Reaumont (FR)**

(74) Mandataire: **Cabinet Laurent & Charras**
**Le Contemporain**
**50 Chemin de la Bruyère**
**69574 Dardilly Cedex (FR)**

(56) Documents cités:
**EP-A2- 0 952 456      FR-A1- 2 942 074**
**JP-A- H0 264 421**

- **BELENKY A ET AL: "Widening the dynamic range of the readout integration circuit for uncooled microbolometer infrared sensors", PROCEEDINGS / 2004 IEEE INTERNATIONAL SYMPOSIUM ON CIRCUITS AND SYSTEMS : MAY 23 - 26, 2004, SHERATON VANCOUVER WALL CENTRE HOTEL, VANCOUVER, BRITISH COLUMBIA, CANADA, IEEE OPERATIONS CENTER, PISCATAWAY, NJ, vol. 5, 23 mai 2004 (2004-05-23), pages 600-603, XP010720335, ISBN: 978-0-7803-8251-0**
- **VIARANI N ET AL: "A 16-Cell 80dB Dynamic-Range Auto-Ranging Read-Out Array for Uncooled IR Micro-Bolometers", SOLID-STATE SENSORS, ACTUATORS AND MICROSYSTEMS CONFERENCE, 2007. TRANSDUCERS 2007. INTERNATIONAL, IEEE, PISCATAWAY, NJ, USA, 10 juin 2007 (2007-06-10), pages 1361-1364, XP031216295, ISBN: 978-1-4244-0841-2**
- **A. Nascetti: "Fractional charge packet counting with constant relative resolution", International Journal of Circuit Theory and Applications, vol. 40, no. 2, 22 June 2010 (2010-06-22), pages 175-187, XP055183702, ISSN: 0098-9886, DOI: 10.1002/cta.714**
- **M TCHAGASPANIAN, P VILLAR, B DUPONT, G CUMMNGS, J.L MARTIN,C. PISTE: "Design of ADC in 25 um pixels pitch dedicated for IRFPA image processing at LETI", PROC. SPIE 6542, INFRARED TECHNOLOGY AND APPLICATIONS XXXIII, 65421W (14 MAY 2007), vol. 6542, 14 May 2007 (2007-05-14), - 14 May 2007 (2007-05-14), XP040239560, Orlando**

**Description**

**DOMAINE DE L'INVENTION**

L'invention a trait au domaine de l'intégration de courant électrique, notamment celui des intégrateurs comprenant un condensateur connecté en contre-réaction sur un amplificateur opérationnel et délivrant une tension électrique qui est fonction des charges reçues et stockées dans le condensateur.

L'invention s'applique notamment, mais non exclusivement, au domaine de la détection de rayonnement électromagnétique, et particulièrement celui de l'infrarouge. Elle s'applique plus spécifiquement au domaine de l'imagerie thermique à l'aide de détecteurs matriciels constitués d'une matrice de micro-bolomètres, qu'il s'agisse de l'imagerie classique destinée à former des images thermiques, ou de l'imagerie thermographique destinée à obtenir des mesures de température.

L'invention vise ainsi notamment un intégrateur à haute dynamique de lecture, c'est-à-dire un intégrateur capable de mesurer un courant électrique correspondant à une faible quantité de charges électriques et de mesurer un courant électrique correspondant à une forte quantité de charges électriques. Notamment, dans le cadre de la détection matricielle, l'invention vise la formation d'images contenant le maximum d'informations utiles, obtenues à partir de scènes présentant une haute dynamique de flux, c'est-à-dire caractérisées par de grands écarts d'énergie émise entre les divers points de la scène, et plus spécialement un écart particulièrement important de température entre zones « froides » et zones « chaudes » en ce qui concerne les détecteurs thermiques, de l'ordre de plusieurs centaines de degrés Celsius.

**ETAT DE LA TECHNIQUE**

Les développements formulés ci-après s'appuient sur le cas particulier des détecteurs thermiques de type microbolométrique, en ce qu'ils bénéficient particulièrement des avantages procurés par l'invention. Cependant, il convient de préciser que les problématiques exprimées dans ce cadre s'appliquent à tout type de dispositif produisant des charges électriques devant être mesurées. Notamment, ce qui est exposé ci-après s'applique à tous les détecteurs de rayonnement électromagnétique, qu'il s'agisse des détecteurs opérant par exemple dans le domaine visible, ou de détecteurs opérant dans l'infrarouge ou au-delà dans les bandes dites « Terahertz ». De même, l'invention bénéficie aussi bien aux détecteurs sensibles aux ondes électromagnétiques, comme les détecteurs thermiques par exemple de type bolométrique et capacitif, ou à antennes de couplage pour les domaines thermique et Terahertz, qu'aux détecteurs dits quantiques, sensibles aux corpuscules d'énergie électromagnétique parmi lesquels on notera les détecteurs opérant dès les bandes X, UV, visible et infrarouge.

Dans le contexte de la présente invention, le terme de « détecteur » peut être entendu comme tout système destiné à produire un signal électrique en relation avec une distribution unitaire, linéaire ou bidimensionnelle d'un phénomène quelconque.

Dans le domaine des détecteurs infrarouges dits « thermiques », il est connu d'utiliser des matrices monodimensionnelles ou bidimensionnelles d'éléments sensibles au rayonnement infrarouge, susceptibles de fonctionner à température ambiante, c'est-à-dire ne nécessitant pas de refroidissement à de très basses températures, contrairement aux dispositifs de détection appelés « détecteurs quantiques », qui eux, nécessitent un fonctionnement à très basse température, typiquement celle de l'azote liquide.

Un détecteur infrarouge thermique utilise traditionnellement la variation d'une grandeur physique d'un matériau approprié dit « thermométrique » ou « bolométrique », en fonction de sa température. Le plus couramment, cette grandeur physique est la résistivité électrique dudit matériau qui varie fortement avec la température. Les éléments sensibles unitaires du détecteur, ou « bolomètres », prennent usuellement la forme de membranes, comprenant chacune une couche en matériau thermométrique, et suspendue au-dessus d'un substrat, généralement réalisé en silicium, via des bras de soutien de résistance thermique élevée, la matrice de membranes suspendues étant usuellement désignée sous le terme de « rétine ». Ces membranes mettent notamment en œuvre une fonction d'absorption du rayonnement infrarouge incident, une fonction de conversion de la puissance du rayonnement absorbé en puissance calorifique, et une fonction thermométrique de conversion de la puissance calorifique produite en une variation de la résistivité du matériau thermométrique, ces fonctions pouvant être mises en œuvre par un ou plusieurs éléments distincts. Par ailleurs, les bras de soutien des membranes sont également conducteurs et connectés à la couche thermométrique de celles-ci. Il est usuellement ménagé dans le substrat au-dessus duquel sont suspendues les membranes, des moyens d'adressage et de polarisation séquentiels des éléments thermométriques des membranes, et des moyens de formation des signaux électriques utilisables en formats vidéo. Ce substrat et les moyens intégrés sont communément désignés par l'expression « circuit de lecture ».

Pour compenser la dérive en température du détecteur, une solution généralement mise en œuvre est la disposition, dans le circuit électronique de formation du signal en relation avec la température des bolomètres d'imagerie (ainsi nommés car sensibles au rayonnement électromagnétique incident), d'un élément de compensation de température du plan focal (*TPF*) lui-même bolométrique, c'est-à-dire dont le comportement électrique suit la température du substrat, mais reste essentiellement insensible au rayonnement. Ce résultat est obtenu par exemple au moyen de structures bolométriques dotées par construction d'une faible résistance thermique vers le substrat, et/ou en masquant ces structures derrière un écran opaque au rayonnement thermique. La mise en œuvre de ces éléments de compensation offre par ailleurs l'avantage d'éliminer l'essentiel du courant dit de mode commun issu des bolomètres d'imagerie ou « actifs ».

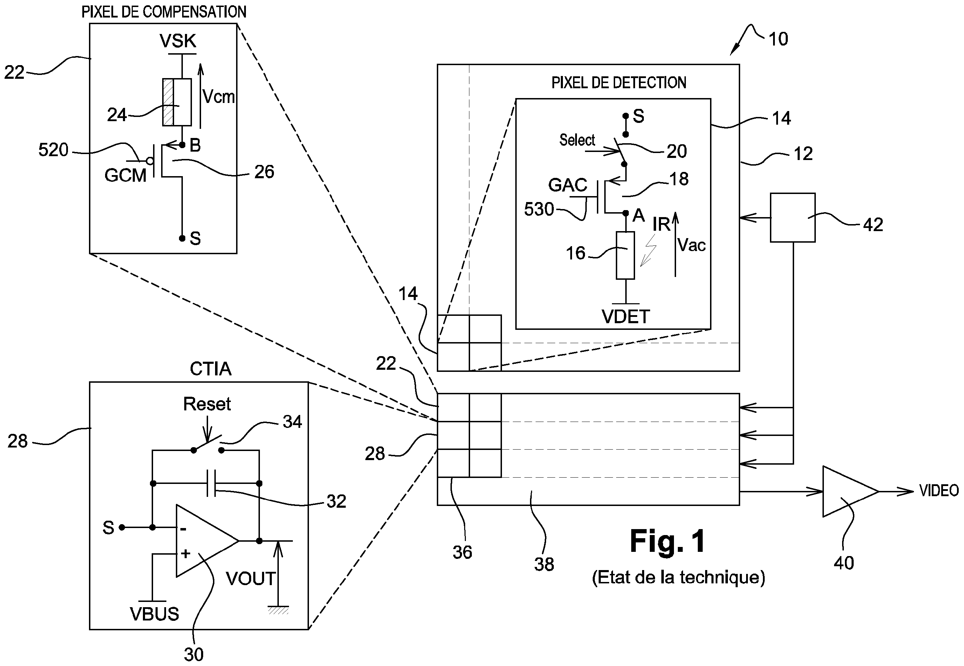

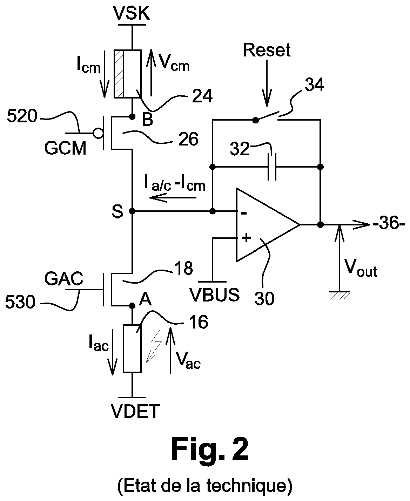

La figure 1 est un schéma électrique d'un détecteur bolométrique **10** sans régulation de température, ou détecteur « *TECless* », de l'état de la technique, comprenant une structure de compensation du mode commun, et la figure 2 est un schéma électrique d'un circuit mis en œuvre pour former un signal de lecture d'un bolomètre du détecteur compensé du mode commun. Un tel détecteur est par exemple décrit dans le document : « Uncooled amorphous silicon technology enhancement for $25\mu m$ pixel pitch achievement » ; E. Mottin et al, Infrared Technology and Application XXVIII, SPIE, vol. 4820E.

Le détecteur **10** comprend une matrice bidimensionnelle **12** d'éléments unitaires de détection bolométriques **14** identiques, ou « pixels », comprenant chacun un bolomètre résistif sensible **16** sous la forme d'une membrane suspendue au-dessus d'un substrat, tel que décrit précédemment, et de résistance électrique $R_{ac}$.

Chaque bolomètre **16** est connecté par l'une de ses bornes à une tension constante *VDET,* notamment la masse du détecteur **10,** et par l'autre de ses bornes à un transistor MOS de polarisation **18** fonctionnant en régime saturé, par exemple un transistor NMOS, réglant la tension $V_{ac}$ aux bornes du bolomètre **16** au moyen d'une tension de commande de grille *GAC.*

Si *A* désigne le nœud correspondant à la source du MOS **18** et si *VA* est la tension à ce nœud, qui dépend de la tension de grille *GAC,* la tension $V_{ac}$ est alors égale à $V_{ac}$=*VA-VDET.* Le pixel **14** comprend également un interrupteur de sélection **20,** connecté entre le transistor MOS **18** et un nœud *S* prévu pour chaque colonne de la matrice **12,** et piloté par un signal de commande *Select,* permettant la sélection du bolomètre **16** pour sa lecture. Le transistor **18** et l'interrupteur **20** sont usuellement formés dans le substrat sous l'emprise de la membrane du bolomètre **16.** Les éléments **16** et **18** forment une branche dite de détection. Notamment, les pixels étant identiques et la tension *VDET* d'une part et la tension *GAC* d'autre part étant identiques pour tous les pixels, les bolomètres **16** sont donc polarisés en tension sous la même tension $V_{ac}$. En outre, la tension de grille *GAC* étant constante, la tension $V_{ac}$ est donc également constante.

Le détecteur **10** comporte également, en pied de chaque colonne de la matrice **12,** une structure de compensation **22,** également usuellement désignée sous le terme de structure « d'ébasage » ou de « skimming ». Comme cela est décrit précédemment, la valeur de la résistance électrique des bolomètres de détection **16** est dictée en grande partie par la température du substrat. Le courant parcourant un bolomètre de détection **16** comporte ainsi une importante composante qui dépend de la température du substrat et est indépendante de la scène observée. La structure de compensation **22** a pour fonction de produire un courant électrique à des fins de compensation partielle ou totale de cette composante.

La structure **22** comporte un bolomètre de compensation **24,** de résistance électrique $R_{cm}$, rendu insensible au rayonnement incident issu de la scène à observer. Le bolomètre **24** est construit au moyen du même matériau thermométrique que le bolomètre **16,** mais présente une très faible résistance thermique vers le substrat. Par exemple :

- les éléments résistifs du bolomètre de compensation **24** sont réalisés directement au contact du substrat, ou
- le bolomètre **24** comporte une membrane similaire à celle des bolomètres de détection **16** suspendue au-dessus du substrat au moyen de structures présentant une résistance thermique très faible, ou encore
- le bolomètre de compensation **24** comprend une membrane et des bras de soutien sensiblement identiques à ceux des bolomètres de détection **16** et un matériau bon conducteur thermique remplit l'espace entre la membrane du bolomètre **24** et le substrat.

La résistance électrique du bolomètre **24** est ainsi essentiellement dictée par la température du substrat, le bolomètre **24** est alors dit « thermalisé » au substrat.

Le bolomètre **24** est connecté à l'une de ses bornes à une tension constante positive *VSK,* et la structure de compensation **22** comporte en outre un transistor MOS de polarisation **26** fonctionnant en régime saturé, de polarité opposée à celle des transistors **18** des pixels de détection **14,** par exemple un transistor PMOS, réglant la tension $V_{cm}$ aux bornes du bolomètre **24** au moyen d'une tension de commande de grille *GCM,* et connecté entre l'autre borne du bolomètre de compensation **24** et le nœud *S.*

Si on désigne par *B* le nœud correspondant au drain du MOS **26** et par *VB* la tension à ce nœud, la tension $V_{cm}$ est alors égale à $V_{cm}$=*VSK-VB*. Les éléments **24** et **26** forment une branche dite de compensation commune à chaque colonne.

La valeur du courant de mode commun de compensation est définie par la valeur de la résistance $R_{cm}$ du bolomètre **24** et des paramètres de polarisation de ce dernier.

Le détecteur **10** comporte également, en pied de chaque colonne de la matrice **12,** un intégrateur **28** de type CTIA (pour l'expression anglo-saxonne « *Capacitive Trans Impedance Amplifier* ») comportant par exemple un amplificateur opérationnel **30** et un unique condensateur **32,** de capacité $C_{int}$ fixe, connecté entre l'entrée inverseuse et la sortie de l'amplificateur **30.** L'entrée inverseuse et l'entrée non-inverseuse de ce dernier sont par ailleurs connectées respectivement au nœud **S** et à une tension constante positive *VBUS.* La tension *VBUS* constitue ainsi une référence pour les signaux de sortie, et est comprise entre *VDET* et *VSK.* Un interrupteur **34,** piloté par un signal *Reset* est également prévu en parallèle du condensateur **32,** pour la décharge de celui-ci. Les sorties des CTIA **28** sont enfin par exemple connectées à des échantillonneurs-bloqueurs (« *Sample and Hold* ») **36** respectifs pour la délivrance des tensions $V_{out}$ des CTIA en mode multiplexé au moyen d'un multiplexeur **38** vers un ou des amplificateur(s) série de sortie **40.** Il peut être également intégré en sortie des moyens de numérisation par convertisseurs analogique - numérique (*ADC* en anglais).

Le détecteur **10** comprend enfin une unité de séquencement **42** commandant les différents interrupteurs décrits précédemment.

En fonctionnement, la matrice **12** est lue ligne par ligne. Pour lire une ligne de la matrice **12,** les interrupteurs **20** de la ligne de pixels **14** sont fermés et les interrupteurs **20** des autres lignes sont ouverts. La lecture successive de l'ensemble des lignes de la matrice **12** constitue une trame.

Pour la lecture d'un bolomètre **16** d'une ligne de la matrice **12** sélectionnée pour la lecture, après une phase de décharge des condensateurs des CTIA en pied de colonne, réalisée par la fermeture des interrupteurs **34** au moyen du signal *Reset* suivi de leur ouverture, il est ainsi obtenu un circuit tel que représenté sur la figure 2 pour chaque pixel de la ligne en cours de lecture.

Un courant $I_{ac}$ circule dans le bolomètre de détection **16** du pixel sous l'effet de sa polarisation en tension par le transistor MOS **18,** et un courant $I_{cm}$ circule dans le bolomètre de compensation **24** de la structure de compensation sous l'effet de sa polarisation en tension par le transistor MOS **26.** Ces courants sont soustraits l'un de l'autre au niveau du nœud **S,** et la différence de courants résultante est intégrée par le CTIA **28** pendant une durée d'intégration prédéterminée $T_{int}$. La tension de sortie $V_{out}$ du CTIA **28** représente ainsi une mesure de la variation de la résistance du bolomètre de détection **16** provoquée par le rayonnement incident à détecter, puisque la partie non utile du courant $I_{ac}$ liée à la température du substrat est compensée, au moins en partie, par le courant $I_{cm}$ spécifiquement produit pour reproduire cette partie non utile.

En supposant que les résistances électriques des bolomètres actif **16** et de compensation **24** ne sont pas modifiées ne manière significative lors de leur polarisation par un phénomène d'auto-échauffement, et que le CTIA **28** ne sature pas, la tension de sortie $V_{out}$ de l'intégrateur à la fin du temps d'intégration $T_{int}$ s'exprime par la relation :

$$V_{out} = V_{bus} + \frac{1}{C_{int}} \int_{0}^{\Delta T_{int}} (i_{ac} - i_{cm})dt = \frac{(i_{ac} - i_{cm}) \cdot T_{int}}{C_{int}} + VBUS \qquad (1)$$

Comme cela est connu en soi, un CTIA a une dynamique électrique de sortie, ou dynamique « de lecture », fixe. En dessous d'une première quantité de charges électriques reçue en entrée, le CTIA délivre une tension basse fixe, dite « tension de saturation basse » ($V_{satL}$). De même, au-dessus d'une seconde quantité de charges électriques reçue en entrée, le CTIA délivre une tension haute fixe dite «tension de saturation haute » ($V_{satH}$). La relation (1) exprime le comportement linéaire du CTIA, lorsque celui-ci reçoit une quantité de charges électriques supérieure à la première quantité de charges électrique, et inférieure à la seconde quantité de charges électriques. La dynamique de lecture est essentiellement fixée par la valeur de la capacité $C_{int}$ du condensateur **32.** Notamment, lorsque cette capacité est fixe, c'est-à-dire constante dans le temps, la dynamique de lecture du CTIA est également fixe.

Par convention, dans le cadre de l'invention, les tensions de saturation basse $V_{satL}$ et haute $V_{satH}$ sont les limites entre lesquelles le CTIA fournit une sortie considérée comme linéaire, même s'il est en général capable de fournir des tensions plus basses ou plus élevées que ces bornes.

Par ailleurs, la capacité d'intégration détermine aussi la sensibilité, ou plus exactement la réponse (plus connue sous le terme anglais de « *responsivity* ») du détecteur. La réponse d'un détecteur est définie par la variation du signal de sortie $V_{out}$ en relation avec la variation du signal d'entrée (la température de scène $T_{scène}$), soit $dV_{out}/dT_{scène}$. La dynamique observable de la scène, ou « dynamique de scène » est quant à elle définie par l'écart maximal de températures dans une scène n'entrainant aucune saturation des signaux en sortie des CTIA, ou, dit autrement, la différence entre la plus haute température n'induisant pas de saturation haute des CTIA et la plus faible des températures n'induisant pas la saturation basse des CTIA. La sensibilité (réponse) d'un détecteur est par conséquent l'aptitude de ce dernier à détecter les détails d'une scène alors que la dynamique de scène du détecteur est son aptitude à transcrire sans distorsion de très larges variations de températures dans une scène. Il est ainsi impossible d'optimiser simultanément ces deux grandeurs contradictoires avec une capacité d'intégration fixe.

L'état de la technique propose de privilégier donc l'une ou l'autre de ces grandeurs en fonction de l'application visée. Usuellement, l'utilisateur opte soit pour une sensibilité élevée, et la dynamique de scène observable s'en trouve nécessairement réduite, par exemple à quelques dizaines de degrés, soit pour une dynamique de scène élevée, par exemple 200°C, et le détecteur ne dispose que d'une sensibilité modeste quelle que soit la scène observée. En d'autres termes, l'utilisateur règle le point de fonctionnement du détecteur de façon à répondre au mieux à son besoin en termes de compromis entre sensibilité et dynamique de scène.

Les considérations précédentes s'appliquent à tout système formant un courant électrique de signal d'entrée $I_{in}$, dont un exemple est la différence $i_{ac} - i_{cm}$ décrite ci-dessus, destiné à être « lu » au moyen d'un intégrateur, notamment du type CTIA. Dans ce cadre large, il s'agit de traiter l'antagonisme inhérent entre le besoin de haute dynamique acceptable en entrée (ici, au niveau de la scène thermique) et le besoin contradictoire de gain élevé de la chaine de formation du signal qui définit la sensibilité du système, en particulier le gain de l'intégrateur $dV_{out}/dI_{in} = T_{int}/C_{int}$.

Des dispositions complexes ont été proposées pour adapter la dynamique de lecture d'un intégrateur à la quantité de charges électriques qu'il reçoit. Dans le cadre d'une application au domaine de la détection, cela permet d'étendre la dynamique de scène tout en conservant une sensibilité élevée.

Ainsi, le document Proc. of SPIE Vol. 6940, 694020, (2008) propose de mettre en parallèle deux condensateurs sélectionnables en lieu et place de l'unique condensateur **32,** un condensateur ayant une capacité faible et un condensateur ayant une capacité élevée. Pour la lecture de la matrice de détecteurs unitaires, un mode dit « combiné » (« *combined mode* ») est mis en œuvre. Ce mode alterne une formation d'une trame avec un fort gain par la sélection des condensateurs de faible capacité pour les CTIA, et donc à forte sensibilité, suivie de la formation d'une trame avec faible gain par la sélection des condensateurs à capacité élevée pour les CTIA, et donc à grande dynamique de scène.

Le défaut de ce mode de fonctionnement réside dans la limitation de la disponibilité des données de haut débit en temps réel. En effet, seule une trame est affichée pour trois trames lues. La fréquence de trame est donc égale au tiers de la fréquence de trame usuelle.

Le document Proc. of SPIE Vol. 6542, 65421R, (2007) décrit un détecteur matriciel analogue à celui décrit précédemment. Il en diffère cependant par un temps d'intégration variable en fonction de la position des pixels. Notamment, un temps d'intégration élevé est appliqué sur un pixel, et un temps d'intégration plus faible est appliqué à un pixel voisin de ce premier pixel, la répartition spatiale des temps d'intégration étant appliquée à toute la matrice selon un motif en damier. Une fois une trame lue avec les différents temps d'intégration, un séquenceur logique compare le signal issu de chaque pixel à un seuil. Lorsque la tension issue d'un pixel lu avec un fort gain, c'est-à-dire avec le temps d'intégration élevé, dépasse le seuil, cette tension est remplacée dans la trame par la moyenne des tensions issues des pixels voisins lus avec un faible gain, c'est-à-dire avec le temps d'intégration faible. En revanche, lorsque la tension issue d'un pixel lu avec un faible gain est en dessous du seuil, cette tension est remplacée dans la trame par la moyenne des tensions issues des pixels voisins lus avec le fort gain. Il se conçoit aisément la perte importante d'informations, notamment concernant les détails en haute et basse températures puisque la trame modifiée est une moyenne.

Le document WO 2007/135175 décrit un circuit de réinitialisation des pixels d'un capteur d'images, pourvu de CTIA pour la lecture des charges électriques produits par les éléments de détection unitaires. Pendant le temps d'intégration, la tension en sortie de chaque CTIA est échantillonnée successivement trois fois à trois moments fixes :

- la première tension échantillonnée sert à supprimer le bruit de commutation (dit « bruit kTC ») des deux autres tensions acquises, via un dispositif à double échantillonnage corrélé (dit « CDS » pour « *Correlated Double Sampling* ») ;
- la seconde tension permet de capturer les détails de la scène ; et
- la troisième tension permet de gérer une forte dynamique de scène.

Les tensions ainsi obtenues sont ensuite numérisées et traitées à l'aide d'un algorithme complexe qui applique un gain aux deux dernières tensions une fois celles-ci corrigées du bruit kTC et qui choisit lequel sera proposé en sortie de façon à éviter les saturations et proposer une dynamique maximale.

Cette solution est consommatrice d'importants moyens logiciels et mémoriels en raison du traitement conséquent de l'information nécessaire, externe au capteur d'images, et des moyens de formation des signaux. En outre, cette solution produit une information en sortie temporellement décalée par rapport aux évènements de scène, du fait de l'échantillonnage multiple et du temps dédié aux calculs associés. Ce défaut est appelé « non cohérence temporelle » ou asynchronisme.

Le document US 7 202 463 décrit un capteur d'images à photodiodes. Pour la lecture de chaque photodiode, il est prévu un condensateur connecté en parallèle de celle-ci qui intègre les charges électriques produites par la photodiode. Un comparateur est connecté au condensateur pour comparer la tension de celui-ci à une tension de seuil et un circuit de décharge du condensateur, connecté en sortie du comparateur, décharge le condensateur lorsque sa tension est supérieure à la tension de seuil. Enfin, une circuiterie est également prévue pour compter le nombre de dépassements de la tension de seuil par la tension du condensateur pendant la période d'intégration. Le signal final est alors restitué en multipliant la tension seuil par le nombre de dépassements comptés, à laquelle est ajoutée la valeur finale de la tension du condensateur capteur. Ce système permet d'obtenir une grande dynamique de scène, mais en raison de la décharge répétée de la capacité d'intégration, le signal final est entaché d'un bruit important, d'autant plus élevé que le nombre de décharges du condensateur est élevé. Le document JP H02 264421 décrit également un capteur d'images à photodiodes avec un circuit d'intégration dans lequel le condensateur d'intégration peut être retourné durant la période d'intégration pour éviter une saturation du montage intégrateur.

**EXPOSE DE L'INVENTION**

Le but de la présente invention est de proposer un dispositif d'intégration de courant électrique à base de CTIA, qui présente une dynamique de lecture étendue sans compromettre la sensibilité du système, tout en limitant le bruit dans le signal final délivré.

A cet effet, l'invention a pour objet un dispositif d'intégration d'un courant électrique selon la revendication 1.

Selon l'invention, le dispositif comporte en outre :

- un circuit de commutation des bornes du condensateur ; et
- un circuit de déclenchement du circuit de commutation au moins une fois pendant la durée d'intégration $T_{int}$ lorsque la tension de sortie $V_{out}$ de l'amplificateur opérationnel à la fois varie selon ladite direction de variation et est sensiblement égale à une tension de référence $VREF,$

  o lorsque ledit sens de variation est croissant, ladite tension de référence $VREF$ étant inférieure ou égale à la tension de saturation haute $V_{satH},$ et la tension de référence $VREF$ et la tension $VBUS$ de la seconde entrée de l'amplificateur opérationnel sont choisies de manière à satisfaire la relation 2. $VBUS - VREF \geq V_{satL}$ ; ou
  o lorsque ledit sens de variation est décroissant, ladite tension de référence $VREF$ étant supérieure ou égale à la tension de saturation basse $VsatL,$ et la tension de référence $VREF$ et la tension $VBUS$ de la seconde borne d'entrée de l'amplificateur opérationnel (62) sont choisies de manière à satisfaire la relation 2. $VBUS - VREF \leq V_{satH}$

- un circuit de mémorisation pour mémoriser le nombre de déclenchements survenus entre l'instant initial et l'instant final de la période d'intégration.

Par commutation des bornes du condensateur, ou plus simplement, « commutation du condensateur », il est entendu l'interruption momentanée de la continuité électrique entre les armatures A1 et A2 du condensateur d'intégration et leurs nœuds respectifs de connexion au circuit N1 et N2, puis la formation d'une nouvelle continuité électrique entre A1 et N2 et entre A2 et N1 du circuit.

En d'autres termes, grâce à la commutation du condensateur, il est obtenu une extension automatique et autonome de la dynamique de lecture du CTIA en fonction de la quantité de charges électriques reçues, sans modification de la sensibilité de la chaine de formation du signal, en particulier de la valeur du condensateur et du temps d'intégration. Lorsque la tension en sortie du CTIA atteint la tension de référence, le condensateur est commuté sans être déchargé. Les charges électriques conservées définissent, en suite à la commutation, une nouvelle tension en sortie du CTIA, inférieure (lorsque la tension de sortie est croissante) à celle avant commutation, à partir de laquelle l'intégration se poursuit. Le signal utile en sortie est déterminé en fonction du nombre de commutations, du décrément (ou incrément) de tension produit par une commutation et optionnellement de la tension en sortie du CTIA à la fin du temps d'intégration.

En outre, le condensateur n'étant jamais déchargé, le bruit est limité. De plus, le dispositif forme un signal d'image en cohérence temporelle avec les charges reçues, sans recours à un traitement numérique ou/et algorithmique complexe postérieur à la formation de signaux issus de plusieurs pixels. En outre, les circuits supplémentaires mis en œuvre par rapport à un simple CTIA sont très peu consommateurs d'énergie et de surface de substrat, et à dynamique extensible selon le besoin.

Avantageusement, le nombre de commutations réalisées sur l'étendue du temps d'intégration et la tension en sortie du CTIA sont délivrés conjointement pour chaque site de détection. Notamment, selon une caractéristique avantageuse de l'invention, le circuit de mémorisation produit en sortie un signal digital sur n bits codant le nombre de charges électriques à ajouter à la charge correspondant au signal analogique en sortie du CTIA à la fin de la période d'intégration.

Selon l'invention le circuit de commutation comporte :

- un premier interrupteur pilotable connecté entre la première entrée de l'amplificateur opérationnel et la première borne du condensateur ;
- un second interrupteur pilotable connecté entre la sortie de l'amplificateur opérationnel et la seconde borne du condensateur ;
- un troisième interrupteur pilotable connecté entre la première entrée de l'amplificateur opérationnel et la seconde borne du condensateur ;

- un quatrième interrupteur pilotable connecté entre la sortie de l'amplificateur opérationnel et la première borne du condensateur,

et le premier et le second interrupteurs pilotables sont commandés par un premier signal de commande binaire, le troisième et le quatrième interrupteurs pilotables sont commandés par un second signal de commande binaire, le second signal binaire étant le complément du premier signal binaire.

Selon un mode de réalisation, le circuit de déclenchement comporte un comparateur ayant une première entrée connectée à la sortie de l'amplificateur et une seconde entrée connectée à la tension de référence, le comparateur produisant une première tension sur sa sortie lorsque la tension sur sa première entrée est inférieure à la tension sur sa seconde entrée, et produisant une seconde tension, différente de la première tension, sur sa sortie lorsque la tension sur sa première entrée est supérieure à la tension sur sa seconde entrée, de sorte qu'une condition nécessaire au déclenchement du circuit de commutation mise en œuvre par le circuit de déclenchement est réalisée :

- lors du basculement de la première tension vers la seconde tension si ledit sens de variation est croissant ; ou
- lors du basculement de la seconde tension vers la première tension si ledit sens de variation est décroissant.

Selon un mode de réalisation, le déclenchement de la commutation du condensateur mis en œuvre par le circuit de déclenchement consiste en la réunion :

- d'une première sous-condition consistant en ce que la tension de sortie de l'amplificateur opérationnel varie selon ledit sens de variation et est sensiblement égale à la tension de référence ; et
- d'une deuxième sous-condition consistant en ce que le nombre de fois où la première sous-condition a été satisfaite depuis l'instant initial de la durée d'intégration est inférieur à un nombre maximal prédéterminé.

Plus particulièrement, le circuit de déclenchement comporte un compteur binaire sur n bits ayant une entrée de comptage connectée à la sortie du comparateur et une sortie délivrant le nombre de fois depuis l'instant initial de la durée d'intégration $T_{int}$ où la sortie du comparateur bascule de la première tension à la second tension lorsque ledit sens de variation est croissant ou bascule de la seconde tension à la première tension lorsque ledit sens de variation est décroissant.

Le nombre maximal de commutations de la deuxième sous-condition, strictement supérieur à 1, est déterminé en fonction de l'application visée. Il peut être notamment suffisamment grand, pour que le nombre maximal de commutations ne soit que rarement ou jamais atteint en pratique et que le nombre de commutations soit donc en pratique déterminé par la fin de la période d'intégration.

Notamment, le circuit de déclenchement comporte un générateur de signaux connecté à la sortie du compteur binaire et basculant les premier et second signaux de commande binaires des interrupteurs lorsque la sortie du compteur binaire est incrémentée.

L'invention a également pour objet un système de détection de rayonnement électromagnétique comprenant :

- un élément de détection produisant sur une borne de sortie un courant électrique en fonction du rayonnement électromagnétique ; et
- un dispositif du type décrit ci-dessus, la première borne d'entrée de l'amplificateur opérationnel étant apte à être connectée à la borne de sortie de l'élément de détection pour l'intégration du courant produit par l'élément de détection.

Notamment, l'élément de détection comprend :

- une branche de détection, comprenant un bolomètre de détection ayant une membrane suspendue au-dessus d'un substrat et un circuit de polarisation pour régler la tension aux bornes du bolomètre de détection en fonction d'une consigne de tension ;
- une branche de compensation, comprenant un bolomètre de compensation porté sensiblement à la température du substrat, et un circuit de polarisation pour régler la tension aux bornes du bolomètre de compensation en fonction d'une consigne de tension ;
- et des moyens pour former la différence entre le courant parcourant le bolomètre de détection et le courant parcourant le bolomètre de compensation de manière à former le courant électrique à intégrer.

L'invention a également pour objet un procédé d'intégration d'un courant électrique selon la revendication 8.

Selon un mode de réalisation, le condenseur est commuté tant que la valeur de comptage est inférieure à une valeur maximale prédéterminée.

## BREVE DESCRIPTION DES FIGURES

L'invention sera mieux comprise à la lecture de la description qui va suivre, donnée uniquement à titre d'exemple, et réalisée en relation avec les dessins annexés, dans lesquels des références identiques désignent des éléments identiques ou analogues, et dans lesquels :

- la figure 1 est un schéma électrique d'un détecteur bolométrique infrarouge de l'état de la technique comportant des intégrateurs de type CTIA pour la mesure des courants produits par les éléments de détection, déjà décrit ci-dessus ;
- la figure 2 est un schéma électrique illustrant la lecture d'un bolomètre sensible du détecteur de la figure 1 à l'aide d'une structure de compensation ;
- la figure 3 est un schéma électrique d'un dispositif d'intégration de courant électrique selon l'invention ;
- la figure 4 est un chronogramme illustrant le signal de sortie de l'étage d'intégration et des signaux de remise à zéro du dispositif de la figure 2 ; et
- la figure 5 est un chronogramme illustrant une extension de la dynamique de lecture du dispositif de la figure 3 dans le cadre d'une utilisation de ce dispositif en tant que dispositif d'intégration d'un détecteur matriciel.

## DESCRIPTION DETAILLEE DE L'INVENTION

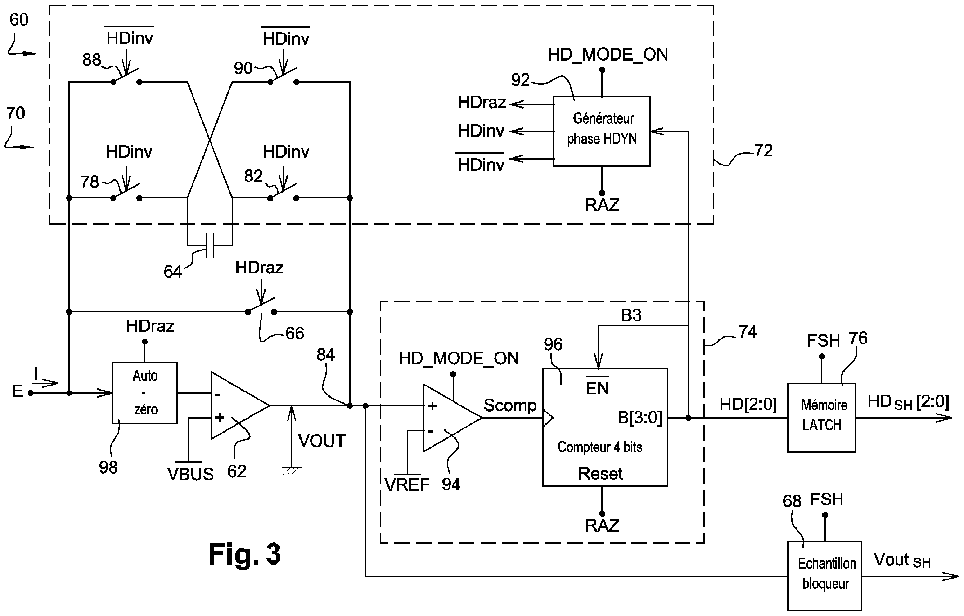

En se référant à la figure 3, un dispositif d'intégration **60** selon l'invention comporte un intégrateur de type CTIA comprenant un amplificateur opérationnel **62** et un unique condensateur **64,** de capacité $C_{int}$ fixe, connecté entre l'entrée inverseuse et la sortie de l'amplificateur **62**. L'entrée non-inverseuse (+) de ce dernier est connectée à une tension positive et constante *VBUS* et l'entrée inverseuse (-) est connectée au nœud d'entrée ou d'intégration E par lequel circule un courant électrique I à intégrer.

Un interrupteur **66,** piloté par un signal *HDraz,* est également prévu en parallèle du condensateur **64,** pour la décharge de celui-ci, et donc sa « remise à zéro ».

Le dispositif **60** est complété d'un échantillonneur bloqueur **68** connecté à la sortie de l'amplificateur opérationnel **62** pour échantillonner et bloquer la tension $V_{out}$ en sortie de ce dernier.

Outre l'étage intégrateur CTIA décrit ci-dessus, le dispositif **60** est complété par une circuiterie **70** d'extension automatique de la dynamique de lecture du seul CTIA **62, 64**. Cette circuiterie **70** comprend :

- un circuit **72** inversant le sens de la connexion du condensateur 64 aux bornes de l'amplificateur opérationnel **62** sur réception d'un signal de commande *HD*[*2:0*] ;
- un circuit **74** détectant une condition de commutation du condensateur **64** en fonction de la tension $V_{out}$ en sortie de l'amplificateur **62** et générant le signal de commande *HD*[2:0] ; et
- un circuit **76** mémorisant le nombre de commutations du condensateur **64.**

Le circuit de commutation **72** comprend :

- un premier interrupteur pilotable **78** connecté entre l'entrée inverseuse (-) de l'amplificateur **62** et une première borne **80** du condensateur **64,** le premier interrupteur étant piloté par un premier signal de commande *HDinv ;*
- un second interrupteur pilotable **82** connecté entre la sortie **84** de l'amplificateur **62** et une seconde borne **86** du condensateur **64,** le second interrupteur étant piloté par le premier signal de commande *HDinv ;*
- un troisième interrupteur pilotable **88** connecté entre l'entrée inverseuse (-) de l'amplificateur **62** et la seconde borne **86** du condensateur **64,** le troisième interrupteur étant piloté par un second signal de commande $\overline{HDinv}$;
- un quatrième interrupteur pilotable **90** connecté entre la sortie **86** de l'amplificateur **62** et la première borne **80** du condensateur **64,** le quatrième interrupteur étant piloté par le second signal de commande $\overline{HDinv}$ ; et
- un générateur de phase **92** recevant le signal de commande *HD*[2:0] et produisant les signaux de commande *HDinv* et $\overline{HDinv}$ en fonction de celui-ci.

Notamment, les signaux *HDinv* et $\overline{HDinv}$ sont en opposition de phase. Par exemple, ce sont des signaux binaires qui sont des compléments logiques l'un de l'autre. Ainsi, les premier et second interrupteurs **78, 82,** qui présentent le même état, sont ouverts alors que les troisième et quatrième interrupteurs **88, 90,** qui présentent le même état, sont fermés et vice versa. Deux états de connexion du condensateur **64** sont ainsi définis, à savoir :

- un premier état dans lequel les première et seconde bornes **80, 86** du condensateur **64** sont respectivement connectées au nœud E et à la sortie **84** de l'amplificateur **62,** et

- un second état dans lequel les première et seconde bornes **80, 86** du condensateur **64** sont respectivement connectées à la sortie **84** de l'amplificateur **62** et au nœud E.

Le basculement du signal *HDinv,* et donc du signal $\overline{HDinv},$ provoque par conséquent l'inversion de l'état de connexion du condensateur **64,** c'est-à-dire sa commutation.

Le générateur de phase **92** produit également le signal *HDraz* pilotant l'interrupteur de remise à zéro **66** du condensateur **64** en fonction d'un signal de commande d'initialisation *RAZ* d'une manière expliquée ci-après.

Le générateur de phase **92** met également en œuvre une fonction d'activation et de désactivation du mode d'extension automatique de la dynamique de lecture en fonction d'un signal de sélection de mode *HD_MODE_ON,* d'une manière qui sera également décrite ci-dessous.

Le circuit de détection **74** comporte quant à lui :

- un comparateur **94** recevant sur une première borne (+) la tension $V_{out}$ en sortie de l'amplificateur **62** et, sur une seconde borne (-) une tension de référence *VREF* supérieure à la tension *VBUS* et inférieure ou égale à la tension de saturation haute $V_{satH}$ du CTIA. Le comparateur **94** produit en sortie une tension $S_{comp}$ ayant une première valeur lorsque la tension $V_{out}$ est inférieure à la tension *VREF,* et ayant une seconde valeur, différente de la première valeur, lorsque la tension $V_{out}$ est supérieure ou égale à la tension *VREF.* Notamment, le basculement de la tension $S_{comp}$ depuis la première valeur sur la seconde valeur signifie que la tension $V_{out}$ est croissante et vient de franchir la tension de référence *VREF*;
- un compteur binaire **96,** dont l'entrée de comptage est connectée à la sortie du comparateur **94.** Le compteur binaire est par exemple conçu pour compter les fronts montant d'impulsions, la seconde valeur de tension du comparateur étant alors choisie supérieure à la première valeur de tension. Le compteur **96** a un nombre de bits prédéterminé, par exemple 4, et reçoit sur une borne d'initialisation le signal d'initialisation *RAZ* pour sa remise à zéro. Par ailleurs, le compteur **96** est configuré pour être bloqué une fois sa valeur maximale atteinte. Enfin, le signal en sortie du compteur binaire **96,** qui est par exemple délivré sur 3 sorties en parallèle, une sortie étant prévue pour chaque bit du compteur, fournit le signal de commande *HD*[2:0] du générateur de phase **92.**

Le circuit de mémorisation **76** est par exemple constitué d'une mémoire numérique asynchrone de type « LATCH », qui reçoit la valeur du compteur contenue dans le signal *HD*[2:0] et maintient cette valeur dans son signal de sortie *HDsh[2:0].* Le circuit de mémorisation **76** et l'échantillonneur bloqueur **68** sont pilotés par le même signal d'échantillonnage *FSH* pour le maintien en sortie des signaux reçus en entrée.

Enfin, le dispositif d'intégration **60** selon l'invention comprend avantageusement un circuit « d'autozéro » **98** connecté sur l'entrée inverseuse (-) de l'amplificateur **62,** afin d'annuler l'offset de l'amplificateur **62** et le bruit basse fréquence de celui-ci d'une manière connue en soi, et par exemple décrite dans le document IEEE journal of solid-state circuits, vol sc-20, n°3, juin 1985.

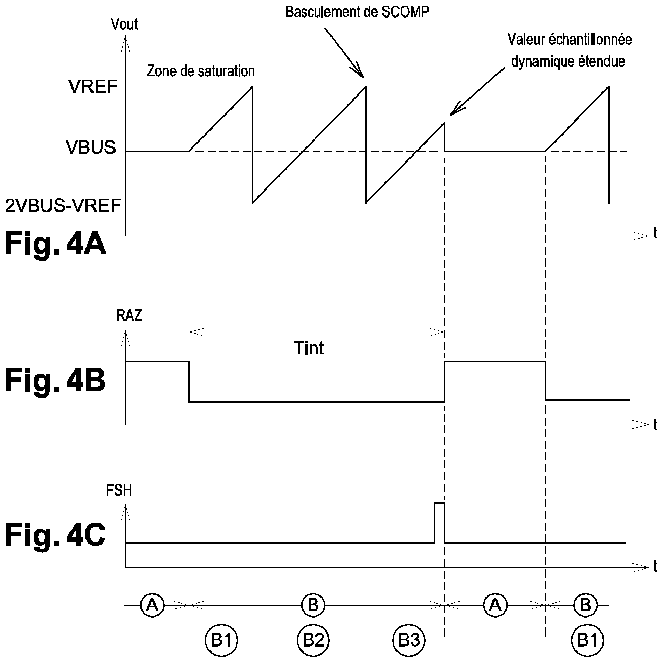

Le fonctionnement du dispositif **60** va à présent être décrit en relation avec les figures 4.

Avant de commencer une phase d'intégration d'un courant électrique *I* (phase « A »), les signaux *HDraz* et *HDinv* sont activés à l'état haut par le générateur **92** sur réception d'une valeur prédéterminée de la commande *RAZ,* le signal complémenté $\overline{HDinv}$ étant donc également porté à l'état bas par le générateur **92.** Les interrupteurs **66, 78** et **82** sont donc dans leur état fermé, les interrupteurs **88, 90** sont dans leur état ouvert et les sorties *HD*[2:0] du compteur **96** sont réglées à l'état bas. La fermeture de l'interrupteur **66** décharge le condensateur **64,** et suite à cette mise à zéro, la tension de sortie $V_{out}$ est égale à *VBUS.* La tension *VREF* étant supérieure à la tension *VBUS,* la sortie du comparateur **94** est donc réglée à sa valeur la plus faible. Durant cette phase d'initialisation, pendant laquelle le signal *HDraz* est activé à l'état haut, le système d'autozéro **98** est également mis en œuvre d'une manière connue de l'homme de l'art.

La commande *RAZ* est ensuite relâchée, le générateur **92** déclenche l'ouverture de l'interrupteur **66** et conserve l'état des signaux *HDinv* et $\overline{HDinv}.$ L'ouverture de l'interrupteur **66** marque ainsi le début de la phase d'intégration du courant *I* reçu en entrée (phase « B »), le système d'autozéro **98** est actif pour soustraire l'offset en entrée de l'amplificateur **62** durant toute la phase d'intégration. Le générateur **92,** et l'interrupteur **66** forment ainsi un circuit d'initialisation du dispositif qui détermine l'instant du début de la période d'intégration à partir du front descendant du signal *RAZ* jusqu'au front montant du signal *RAZ* qui marque l'instant final de la période d'intégration. Du fait de l'intégration, la tension $V_{out}$ en sortie de l'amplificateur **62** augmente depuis la valeur *VBUS* (phase « B1 »).

Si durant toute la phase d'intégration de durée $T_{int},$ la tension $V_{out}$ reste inférieure à la tension de référence *VREF,* aucune condition logique nouvelle n'apparait en sortie du compteur binaire **96.** Le fonctionnement du dispositif **60** est alors identique à celui d'un CTIA de l'état de la technique, tel que décrit en relation avec les figures 1 et 2, et le signal de sortie *HD*[2:0] reste donc à l'état bas.

En revanche, si au cours de le la phase d'intégration, la tension de sortie $V_{out}$ atteint ou dépasse la valeur *VREF,* la sortie $S_{COMP}$ du comparateur **94** change d'état, lequel propage l'état haut en sortie du comparateur en entrée de l'horloge du compteur binaire **96,** ce qui active alors le bit de poids faible *HD0* à 1. On a alors *HD[2:0]* = 001.

Le basculement d'un bit du signal *HD[2:0]* de l'état bas à l'état haut est détecté par le générateur de phase **92.** En réponse, ce dernier bascule les signaux de commande *HDinv* et $\overline{HDinv}$ respectivement sur l'état bas et l'état haut. Il en résulte la commutation des connexions du condensateur **64** entre l'amplificateur **62** et le circuit autozéro **98.**

Au moment où la condition $V_{out}$ = *VREF* est remplie, la quantité de charges électriques Q stockée dans le condensateur **64** est égale à :

$$Q = C_{int}.(VREF\text{-}VBUS) \qquad (2)$$

Après la commutation du condensateur **64,** la charge Q aux bornes du CTIA est de polarité inverse par rapport à celle présentée avant la commutation, de sorte que la sortie de l'amplificateur **62** est égale à :

$$V_{out}=2.VBUS\text{-}VREF \qquad (3)$$

La sortie du comparateur **94** bascule alors à l'état bas puisque la tension $V_{out}$ est strictement inférieure à la tension de référence *VREF.* La commutation du condensateur **64** ramène ainsi la sortie de l'amplificateur **62** à un niveau plus bas. Afin de ne pas saturer le CTIA, la tension *VBUS* et la tension *VREF* sont choisies de manière à satisfaire la relation :

$$2.VBUS - VREF \geq VsatL$$

Par exemple, la tension *VBUS* est réglée au-dessus, et avantageusement au point central de a dynamique linéaire du CTIA, la tension *VBUS* satisfaisant ainsi la relation :

$$VBUS \geq \frac{V_{satL} + V_{satH}}{2}$$

Au-delà de cet instant, la phase d'intégration se poursuit (phase « B2 »), la sortie de l'amplificateur **62** reprenant sa croissance dans la dynamique linéaire de lecture, sans aucune perte d'information.

Si la sortie $V_{out}$ de l'amplificateur **62** atteint ou dépasse à nouveau la valeur *VREF* avant la fin de l'intégration, la sortie $S_{COMP}$ du comparateur **94** change encore de polarité et incrémente une nouvelle fois le compteur **96**. La sortie binaire de ce dernier est alors réglée à HD[2 :0]=010.

Sur réception du basculement d'un bit du signal *HD[2:0],* le générateur **92** bascule les signaux *HDinv* et $\overline{HDinv}$, dans le cas présent respectivement à l'état haut et l'état bas, ce qui entraine la commutation du condensateur **64**. La charge électrique Q aux bornes du CTIA est à nouveau de polarité inverse par rapport à celle présentée avant la commutation, et la sortie de l'amplificateur **62** est donc ramenée à $V_{out}=2.VBUS\text{-}VREF$ et la sortie du comparateur **94** bascule à l'état bas puisque $V_{out}$<*VREF.* Une nouvelle phase de croissance de la sortie $V_{out}$ depuis la valeur *2.VBUS-VREF* est alors mise en œuvre (phase « B3 »). Le condensateur peut ainsi commuter de manière répétée sans perte d'information jusqu'à la valeur maximum du compteur binaire **96,** à titre d'exemple ici sur 3 bits, soit la valeur maximale $HD_{SH}$[2: 0]=111.

Une fois la durée d'intégration $T_{int}$ écoulée, la tension de sortie $V_{out}$ ($T_{int}$) est échantillonnée et bloquée dans l'échantillonneur-bloqueur **68** par l'envoi d'une impulsion pour le signal *FSH,* comme dans le mode d'intégration classique, tandis que les valeurs binaires du signal *HD[2:0]* sont également stockées dans un étage mémoire de type latch **76** sur réception de l'impulsion du même signal *FSH.* Le dispositif **60** délivre ainsi à l'issue d'une phase d'intégration un signal $HD_{SH}$[2:0] représentant le nombre de commutations du condensateur **64** ainsi que la tension $V_{outSH}$ égale à la tension en sortie d'amplificateur **62**. Le signal *FSH* est par exemple activé à l'état haut par un circuit de gestion des signaux digitaux de commande (non représenté) durant une courte période juste avant la fin de l'intégration, c'est-à-dire avant le front montant du signal *RAZ,* comme indiqué sur les figures 4B et 4C qui précisent aussi les instants de début et fin de la période d'intégration. D'autres mécanismes pour régler les instants de début et de fin de la durée d'intégration sont bien entendu possibles.

La capacité $C_{int}$ de l'étage CTIA et le compteur binaire peuvent alors être réinitialisés à zéro par activation de la commande *RAZ* avant un nouveau cycle d'intégration, comme indiqué précédemment.

Au final, la tension totale $V_{out}^{final}$ correspondant aux charges électriques intégrées par le CTIA **62, 64** pendant la phase d'intégration est donc égale à :

$$V_{out}^{final} = V_{outSH} + 2.conv_{10}(HD_{SH}[2:0]) \times (VREF - VBUS) \qquad (4)$$

où $conv_{10}(HD_{SH}[2:0])$ est la conversion en valeur décimale de $HD_{SH}[2:0]$, c'est-à-dire le nombre de commutations du condensateur.

La dynamique de lecture équivalente peut donc être augmentée de manière automatique de la valeur $2.(2^n)$. $(VREF\text{-}VBUS)$, ou autrement dit multipliée par $2^n$, où $n$ est le nombre de bits du compteur binaire **96,** ce qui peut correspondre à une dynamique beaucoup plus élevée que celle d'un CTIA classique, suivant la valeur maximale du compteur binaire utilisé et la valeur de la tension de référence $VREF$.

Plusieurs variantes sont possibles pour l'exploitation des signaux $HD_{SH}[2:0]$ et $V_{outSH}$.

Dans une première variante, un système de conversion et une unité de calcul complètent le dispositif **60**. L'unité de conversion convertit les signaux $HD_{SH}[2:0]$ et $V_{outSH}$ en valeurs numériques, et l'unité de calcul calcule une tension finale numérique en fonction des valeurs numériques des signaux $HD_{SH}[2:0]$ et $V_{outSH}$ en se basant sur la relation (4).

Dans une seconde variante, un convertisseur numérique-analogique et un additionneur complètent le dispositif **60**. Le convertisseur produit une tension analogique égale à $2. conv_{10}(HD_{SH}[2:0]) \times (VREF \text{ - } VBUS)$ en fonction du signal $HD_{SH}[2:0]$, et l'additionneur additionne la tension ainsi produite avec la tension $V_{outSH}$, voire directement la tension $V_{out}$ en sortie de l'amplificateur **62**.

Dans une troisième variante, une seule sortie Vidéo est utilisée pour la mise en œuvre du détecteur selon l'invention.

Dans une quatrième variante, seul le signal $HD_{SH}[2:0]$ est délivré, celui-ci étant alors considéré comme une conversion en numérique du courant analogique reçu en entrée. Le dispositif selon l'invention est donc dans ce cadre un convertisseur analogique-numérique. Le nombre de bit du compteur et la valeur $VREF$ sont alors choisis pour définir le pas de quantification du convertisseur, ainsi que sa dynamique.

La conception initiale, puis la configuration ou programmation variable en service d'un détecteur selon l'invention, est réalisable aisément par l'homme de métier, au moyen des architectures et protocoles habituels de programmation digitale des détecteurs modernes, par exemple la validation ou l'inhibition à la demande de manière très simple et immédiate de la fonction « dynamique étendue », ou le forçage depuis l'extérieur de l'une des valeurs possibles de la capacité totale d'intégration équivalente $(2^n.C_{int})$.

Une information binaire selon un ou plusieurs bits digitaux indiquant de manière synchrone au signal de sortie si un pixel donné a été l'objet d'une « saturation » ou non est disponible en parallèle à la sortie VIDEO analogique. Cette caractéristique permet de traiter de manière pratique et rapide l'ensemble des données image, comme par exemple la représentation vidéo (gestion sérielle immédiate des données pour exploitation maîtrisée dans la dynamique d'affichage par exemple) ou toute autre utilisation informative ou de traitement analogique ou numérique du flux de données, en relation avec l'occurrence d'un phénomène de « saturation » locale.

Par exemple, dans le cadre d'un détecteur bolométrique, tel que décrit en relation avec les figures 1 et 2, les CTIA **28** sont remplacés par des dispositifs **60** venant d'être décrit. Par exemple, les échantillonneurs-bloqueurs **68** des dispositifs **60** sont les échantillonneurs-bloqueurs **36** et un second multiplexeur est prévu pour délivrer en mode multiplexé les signaux $HD_{SH}[2:0]$. Une unité de conversion et une unité de calcul complètent alors le détecteur pour reconstituer en numérique la tension finale issue de chaque pixel **14**.

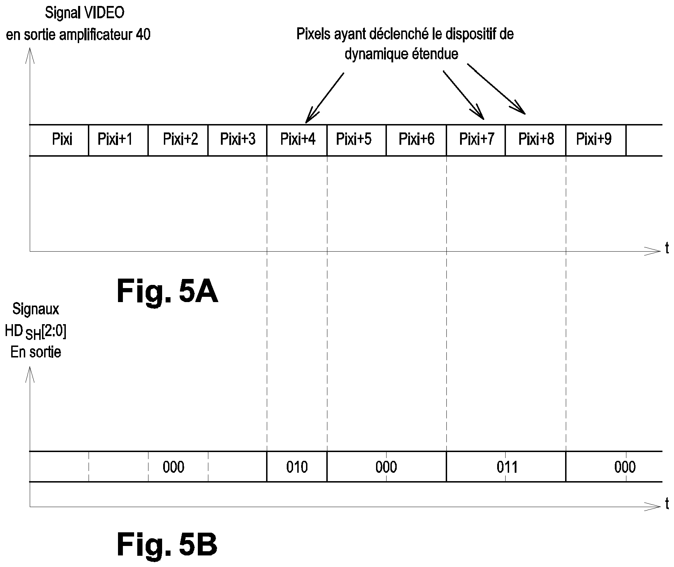

La figure 5 représente un exemple de sortie des signaux binaires $HD[2:0]$ dans un cas particulier où trois pixels « Pix i+4 », « Pix i+7 » et « Pix i+8 », dans une séquence multiplexée quelconque, auraient fait déclencher l'extension de la dynamique selon l'invention en provoquant une à plusieurs fois la commutation du condensateur **46**.

Dans le cadre d'une application à la détection, l'invention permet ainsi le maintien d'une sensibilité optimale sur les zones constituées de tous les pixels qui ne provoquent pas le franchissement de la tension de référence $VREF$, c'est-à-dire qui ne saturent pas, $VREF$ étant choisi inférieur ou égal à la tension de saturation $V_{satH}$, tout en fournissant un signal exploitable sur les zones de l'image où la température de scène est telle qu'elle aurait fait saturer la tension en sortie de l'amplificateur **62** en l'absence de l'invention, c'est-à-dire trop élevée en regard de la dynamique de scène (thermique ici) nominale. La sortie aurait été sur ces zones dépourvue d'information relative à la scène observée. Il est ainsi obtenu à la fois une sensibilité élevée et une dynamique de scène élevée.

Selon une caractéristique avantageuse de l'invention, l'extension de la dynamique de lecture mise en œuvre par le dispositif d'intégration selon l'invention peut être activée ou désactivée de l'extérieur, par exemple au moyen d'une commande manuelle ou de manière logicielle, par une entrée digitale « HD_MODE_ON », telle qu'illustrée sur la figure 3, transmise au moyen d'une interface de programmation, par exemple l'interface dont sont usuellement pourvus les circuits de lecture des détecteurs l'état de la technique, ou encore programmée directement en externe par une entrée dédiée.

Le circuit de lecture incorporant le dispositif selon l'invention peut ainsi être utilisé à tout moment soit en mode normal, c'est-à-dire conformément au mode de fonctionnement décrit en relation avec les figures 1 et 2, soit en mode de « dynamique de scène étendue ». Typiquement, cette commande « *HD_MODE_ON* » force le niveau bas en sortie du comparateur **94,** et de ce fait, le compteur **96** ne change jamais d'état, et la commutation du condensateur **64** n'est donc jamais activée. On notera que le réglage de la tension *VREF* à n'importe quelle valeur supérieure à la tension maximale de sortie du CTIA (en général supérieure à $V_{satH}$ de par les conventions de linéarité précédemment précisées) produit aussi l'effet d'inhiber l'extension de la dynamique de scène du capteur car la sortie $S_{COMP}$ du comparateur **94** est maintenue à l'état bas. Le forçage de *VREF* à la même valeur que la tension d'alimentation de l'amplificateur aura également cet effet inhibiteur sur le dispositif d'extension de la dynamique.

Il a été décrit un unique condensateur **64.** En variante, plusieurs condensateurs sont prévus en parallèle et sélectionnables de manière programmée de manière à former une capacité d'intégration $C_{int}$ programmable sur plusieurs valeurs de manière connue en soi de l'état de la technique. Ceci permet de répondre à différents domaines d'application du détecteur et offre à l'utilisateur un réglage externe de la dynamique de scène. Dans ce mode de réalisation, la variation de la capacité $C_{int}$ est également tracée afin de reconstituer la tension finale, la reconstruction étant à la portée de l'homme du métier.

Il a été décrit un compteur binaire 3 bits. Evidemment, le nombre de bits du compteur dépend de l'application visée. En outre, le nombre de bits peut être choisi très grand de manière à ne jamais atteindre la valeur maximale de celui-ci.

De même, d'autres types de circuit de comptage peuvent être envisagés. Par exemple, la sortie du comparateur **62** est directement connectée à l'entrée du générateur **92** qui pilote les différents signaux en fonction du basculement de la sortie du comparateur, et la sortie du comparateur est délivrée à une unité de traitement d'information qui mémorise le nombre de commutations. Le nombre maximal de commutations est ainsi dicté par la capacité de mémorisation de cette unité et peut être quasiment infini.

Il a été décrit une application particulière selon laquelle la polarité du courant intégré et l'architecture du dispositif d'intégration provoque une augmentation de la tension $V_{out}$ en sortie de l'amplificateur opérationnel en fonction de la quantité de charge stockée dans le condensateur. En variante, la polarité du courant et/ou l'architecture du dispositif d'intégration induit une diminution de la tension $V_{out}$ en sortie de l'amplificateur à mesure que la quantité de charges stockée dans le condensateur augmente. Dans une telle variante, tension *VREF* est choisie supérieure ou égale à la tension de saturation basse $V_{satL}$ et la tension *VBUS* est choisie de manière à satisfaire la relation *2. VBUS - VREF ≤ VsatH*. Le comparateur en sortie de l'amplification bascule alors d'une première valeur à une seconde valeur lorsque la tension $V_{out}$ est décroissante et égale à *VREF,* ce basculement étant compté par le compteur binaire et entrainant la commutation du condensateur.

Il a été décrit une tension de référence *VREF* constante dans le temps. En variante, cette tension est également programmable, sa valeur pouvant varier au cours même de la phase d'intégration.

Selon une variante de mise en œuvre très simplifiée, en ajustant les valeurs de la capacité $C_{int}$ et de la tension de référence *VREF* (en fonction du produit) de manière intégrée dans l'architecture / câblage internes du circuit de lecture, l'utilisateur n'a rien à prévoir en termes de protocole d'acquisition et/ou de traitement d'information pour disposer simultanément d'une dynamique étendue et d'une sensibilité élevée, d'où une facilité d'utilisation extrême.

Un détecteur utilisant l'invention pour intégrer le courant électrique issu d'un site sensible, par exemple un bolomètre, présente un certain nombre d'avantages par rapport aux circuits de lecture de l'état antérieur de la technique, notamment :

- l'accès à une dynamique de scène étendue tout en conservant une grande sensibilité sur la partie de l'image qui est transcriptible dans la dynamique électrique nominale du CTIA seul tandis que la linéarité du signal en fonction du flux est conservée contrairement à certains systèmes à réponse logarithmique par exemple ;
- la fréquence trame (définie par le nombre de fois où l'ensemble de la matrice est lue en l'espace d'une seconde) est conservée à l'identique par rapport aux standards habituels (60Hz par exemple). En d'autres termes, il n'y a pas dégradation de la densité temporelle d'informations par rapport à certaines formes de l'état de l'art en matière d'extension de dynamique ;
- l'information de scène obtenue est maintenue en cohérence temporelle, ou synchronicité, permanente avec la scène. En effet, l'espace de temps séparant un évènement quelconque sur la scène et la formation du signal exploitable par l'observateur ou le système exploitant le flux de sortie des signaux $V_{out}$, n'excède pas un temps trame, contrairement à tous les détecteurs ou systèmes, dont le flux de données est sur-échantillonné ou/et traité par calcul après formation des signaux bruts afin d'obtenir l'information réputée exploitable à dynamique étendue ;
- une simplification de l'utilisation du détecteur. En effet, dans l'état de la technique, l'utilisateur doit généralement lui-même choisir le point de fonctionnement du détecteur en fonction de la gamme des températures de scène observée. En général, pour donner un ordre d'idée, trois points de fonctionnement différents sont nécessaires pour couvrir la dynamique [-40°C ; +1000 °C] sans saturation ;

- par rapport aux méthodes du domaine technique basées sur l'adaptation du temps d'intégration, l'invention procure l'avantage de ne pas modifier le cycle thermique du bolomètre imposé par l'auto-échauffement par effet Joule pendant le cycle d'intégration. Cette caractéristique est particulièrement appréciable quant à la stabilité du niveau continu en fonction des conditions thermiques opératoires ambiantes, en particulier lorsque de petites différences de température de scène sont recherchées avec une bonne stabilité temporelle. L'efficacité de la mise en œuvre éventuelle du détecteur sans module de stabilisation Peltier (opération dite TEC-less en anglais), de plus en plus courante dans le domaine, est donc conservée ;

- Il n'y a pas de bruit de réinitialisation à zéro lors de l'inversion de la capacité d'intégration, comme dans certaines formes de l'art antérieur, car cette dernière n'est jamais vidée, jusqu'après l'instant où le signal $V_{out}$ est échantillonné ;

- Par ailleurs, les capacités parasites que représentent par exemple les grilles des interrupteurs de connexion et les connexions elles-mêmes font partie intégrante de la capacité d'intégration et n'ajoutent en elles-mêmes aucune perturbation parasite. Le signal formé en sortie ne perd donc aucune forme de qualité par suite de l'application de l'invention.

**Revendications**

1. Dispositif (60) d'intégration d'un courant électrique reçu sur un nœud d'intégration pendant une période de durée prédéterminée $T_{int}$, comportant un amplificateur opérationnel (62) ayant une première et une seconde entrée et une sortie, et un condensateur (64) ayant deux bornes adaptés pour être connectés entre la première entrée et la sortie de l'amplificateur opérationnel (62), la seconde entrée de l'amplificateur étant portée à une tension constante $VBUS$, la première entrée de l'amplificateur étant connectée au nœud d'intégration, et la borne de sortie de l'amplificateur opérationnel délivrant une tension de sortie $V_{out}$ qui varie de manière monotone selon un sens de variation prédéterminé en fonction d'une quantité de charges électriques de polarité prédéterminée stockée dans le condensateur (64), la tension $V_{out}$ en sortie de l'amplificateur opérationnel (62) étant saturée à une tension de saturation haute $V_{satH}$ lorsque la quantité de charges électriques de ladite polarité stockées dans le condensateur (64) est supérieure à un seuil prédéterminé, et la tension $V_{out}$ en sortie de l'amplificateur opérationnel (62) étant saturée à une tension de saturation basse $V_{satL}$ lorsque la quantité de charges électriques de ladite polarité stockées dans le condensateur (64) est inférieure à un seuil prédéterminé,
le dispositif (60) comporte en outre :

   - un circuit (72) de commutation des bornes du condensateur ; le circuit (72) de commutation comportant :

      o un premier interrupteur pilotable (78) connecté entre la première entrée de l'amplificateur opérationnel (62) et la première borne du condensateur (64) ;
      o un second interrupteur pilotable (82) connecté entre la sortie de l'amplificateur opérationnel (62) et la seconde borne du condensateur (64) ;
      o un troisième interrupteur pilotable (88) connecté entre la première entrée de l'amplificateur opérationnel (62) et la seconde borne du condensateur (64) ; et
      o un quatrième interrupteur pilotable (90) connecté entre la sortie de l'amplificateur opérationnel (62) et la première borne du condensateur (62),
      o le premier et le second interrupteurs pilotables (78, 82) étant commandés par un premier signal de commande binaire $HDinv$ ;
      o le troisième et le quatrième interrupteur pilotables (88, 90) étant commandés par un second signal de commande binaire $\overline{HDinv}$, le second signal binaire $\overline{HDinv}$ étant le complément du premier signal binaire $HDinv$ ;

   - le basculement du signal $HDinv$, et donc du signal $\overline{HDinv}$, provoquant l'inversion de l'état de connexion du condensateur (64) ; et
   - un circuit (74) de déclenchement du circuit (72) de commutation au moins une fois pendant la durée d'intégration $T_{int}$ lorsque la tension de sortie $V_{out}$ de l'amplificateur opérationnel (62) à la fois varie selon ladite direction de variation et est sensiblement égale à une tension de référence $VREF$ ; et
   - un circuit (76) de mémorisation pour mémoriser le nombre de déclenchements survenus entre l'instant initial et l'instant final de la période d'intégration, le circuit de mémorisation étant couplé à un compteur (96) fournissant le signal de commande du circuit (72) de commutation.

et en ce que :

- lorsque ledit sens de variation est croissant, ladite tension de référence *VREF* est inférieure ou égale à la tension de saturation haute $V_{satH}$, et la tension de référence *VREF* et la tension *VBUS* de la seconde entrée de l'amplificateur opérationnel (62) sont choisies de manière à satisfaire la relation $2.VBUS - VREF \geq V_{satL}$ ; ou
- lorsque ledit sens de variation est décroissant, ladite tension de référence *VREF* est supérieure ou égale à la tension de saturation basse $V_{satL}$, et la tension de référence *VREF* et la tension *VBUS* de la seconde entrée de l'amplificateur opérationnel (62) sont choisies de manière à satisfaire la relation $2.VBUS - VREF \leq V_{satH}$.

2. Dispositif d'intégration d'un courant électrique selon la revendication 1, *caractérisé* **en ce que** le circuit de déclenchement (74) comporte un comparateur (94) ayant une première entrée connectée à la sortie de l'amplificateur opérationnel (62) et une seconde entrée connectée à la tension de référence *VREF,* le comparateur (94) produisant une première tension sur une sortie lorsque la tension sur sa première entrée est inférieure à la tension sur sa seconde entrée, et produisant une seconde tension, différente de la première tension, sur la sortie lorsque la tension sur sa première entrée est supérieure à la tension sur sa seconde entrée, de sorte qu'une condition nécessaire au déclenchement du circuit (72) de commutation mise en œuvre par le circuit (74) de déclenchement est réalisée :

- lors du basculement de la première tension vers la seconde tension si ledit sens de variation est croissant ; ou
- lors du basculement de la seconde tension vers la première tension si ledit sens de variation est décroissant.

3. Dispositif d'intégration d'un courant électrique selon l'une des revendications précédentes, *caractérisé* **en ce que** le déclenchement de la commutation du condensateur (64) mise en œuvre par le circuit (74) de déclenchement consiste en réunion :

- d'une première sous-condition consistant **en ce que** la tension de sortie $V_{out}$ de l'amplificateur opérationnel (62) varie selon ledit sens de variation et est sensiblement égale à la tension de référence *VREF* ; et
- d'une deuxième sous-condition consistant **en ce que** le nombre de fois où la première sous-condition a été satisfaite depuis l'instant initial de la période d'intégration $T_{int}$ est inférieur à un nombre maximal prédéterminé.

4. Dispositif d'intégration d'un courant électrique selon la revendication 3, *caractérisé* **en ce que** le compteur est compris dans le circuit de déclenchement (74), ce compteur étant un compteur binaire sur n bits (96) ayant une entrée de comptage connectée à la sortie du comparateur (94) et une sortie délivrant le nombre de fois depuis l'instant initial de la durée d'intégration *Tint* où la sortie du comparateur (94) bascule de la première tension à la seconde tension lorsque ledit sens de variation est croissant ou bascule de la seconde tension à la première tension lorsque ledit sens de variation est décroissant.

5. Dispositif d'intégration d'un courant électrique selon la revendication précédente, *caractérisé* **en ce que** le circuit de déclenchement (74) comporte un générateur de signaux (92) connecté à la sortie du compteur binaire (94) et basculant les premier et second signaux de commande binaires *HDinv, $\overline{HDinv}$* des interrupteurs (78, 82, 88, 90) lorsque la sortie du compteur binaire (94) est incrémentée.

6. Système de détection de rayonnement électromagnétique comprenant :

- un élément de détection (14, 22) produisant sur une borne de sortie (S) un courant électrique en fonction du rayonnement électromagnétique ; et
- un dispositif (60) selon l'une quelconque des revendications précédentes, la première entrée de l'amplificateur opérationnel (62) étant connectée à la borne (S) de sortie de l'élément de détection (14, 22) pour l'intégration du courant produit par l'élément de détection.

7. Système de détection de rayonnement électromagnétique selon la revendication 6, *caractérisé* **en ce que** l'élément de détection comprend :

- une branche de détection (14), comprenant un bolomètre de détection (16) ayant une membrane suspendue au-dessus d'un substrat et un circuit de polarisation (18) pour régler la tension aux bornes du bolomètre de détection (16) en fonction d'une consigne de tension ;
- une branche de compensation (22), comprenant un bolomètre de compensation (24) porté sensiblement à la température du substrat, et un circuit de polarisation (26) pour régler la tension aux bornes du bolomètre de compensation (24) en fonction d'une consigne de tension ; et

- des moyens pour former la différence entre le courant $i_{ac}$ parcourant le bolomètre de détection (16) et le courant $i_{cm}$ parcourant le bolomètre de compensation (24) de manière à former le courant électrique à intégrer.

8. Procédé d'intégration d'un courant électrique pendant une durée d'intégration prédéterminée $T_{int}$ dans un condensateur (64) ayant deux bornes connectées entre une première entrée et la sortie d'un amplificateur opérationnel (62) au moyen d'un dispositif (60) selon l'une des revendications 1 à 5, l'amplificateur opérationnel comportant une seconde entrée portée à une tension constante $VBUS$, la tension $V_{out}$ en sortie de l'amplificateur opérationnel (62) variant de manière monotone selon un sens de variation prédéterminée en fonction d'une quantité de charges électriques de polarité prédéterminée stockée dans le condensateur (64), ladite tension en sortie $V_{out}$ étant saturée à une tension de saturation haute $V_{satH}$ lorsque la quantité de charges électriques stockées dans le condensateur (64) est supérieure à un seuil prédéterminé, et la tension $V_{out}$ en sortie de l'amplificateur opérationnel (62) étant saturée à une tension de saturation basse $V_{satL}$ lorsque la quantité de charges électriques de ladite polarité stockées dans le condensateur (64) est inférieure à un seuil prédéterminé, le procédé comprenant les étapes suivantes :

   a) avant l'instant initial de la durée d'intégration $T_{int}$, initialisation à zéro de la charge du condensateur (64) et d'une valeur de comptage ;
   b) intégration pendant la durée d'intégration $T_{int}$ du courant électrique dans le condensateur (64) ;
   c) commutation des bornes du condensateur au moins une fois pendant la durée d'intégration $T_{int}$ lorsqu'à la fois la tension de sortie de l'amplificateur opérationnel (62) varie selon ledit sens de variation et est égale à une tension de référence prédéterminée $VREF$,

   o lorsque ledit sens de variation est croissant, ladite tension de référence $VREF$ étant inférieure ou égale à la tension de saturation haute $V_{satH}$, et la tension de référence $VREF$ et la tension $VBUS$ de la seconde entrée de l'amplificateur opérationnel (62) sont choisies de manière à satisfaire la relation 2.$VBUS$ - $VREF$ ≥ $V_{satL}$ ; ou
   o lorsque ledit sens de variation est décroissant, ladite tension de référence $VREF$ étant supérieure ou égale à la tension de saturation basse $V_{satL}$, et la tension de référence $VREF$ et la tension $VBUS$ de la seconde entrée de l'amplificateur opérationnel (62) sont choisies de manière à satisfaire la relation 2. $VBUS$ - $VREF$ ≤ $V_{satH}$ ;

   d) incrémentation d'une unité de la valeur de comptage suite à chaque commutation du condensateur (64) pendant la durée d'intégration $T_{int}$ ; et
   e) après l'instant final de la durée d'intégration $T_{int}$, délivrance de la valeur de comptage.

**Patentansprüche**

1. Vorrichtung (60) zur Integration eines an einem Integrationsknoten während einer vorher festgelegten Dauer $T_{int}$, empfangenen elektrischen Stroms, mit einem operativen Verstärker (62), der über einen ersten und einen zweiten Eingang und einen Ausgang verfügt und mit einem Kondensator (64) mit zwei Klemmen, die zwischen dem ersten Eingang und dem Ausgang des operativen Verstärkers (62) verbunden werden können, der zweite Eingang des Verstärkers wird dabei auf eine konstante Spannung $VBUS$ gebracht, der erste Eingang des Verstärkers ist dabei mit dem Integrationsknoten verbunden, und die Klemme des Ausgangs des operativen Verstärkers liefert dabei eine Ausgangsspannung $V_{out}$, die sich in gleichmäßiger Art und Weise nach einer Variationsrichtung verändert, die entsprechend einer Menge elektrischer Ladungen mit vorher festgelegter Polarität, die im Kondensator (64) gespeichert sind, vorher festgelegt ist, die Spannung $V_{out}$ am Ausgang des operativen Verstärkers (62) ist bei einer hohen Sättigungsspannung $V_{satH}$ gesättigt, wenn die Menge der im Kondensator (64) gespeicherten Ladungen der erwähnten Polarität höher ist, als ein vorher festgelegter Grenzwert und die Spannung $V_{out}$ am Ausgang des operativen Verstärkers (62) ist bei einer niedrigen Sättigungsspannung $V_{satL}$ gesättigt, wenn die Menge der im Kondensator (64) gespeicherten Ladungen der erwähnten Polarität niedriger ist, als ein vorher festgelegter Grenzwert die Vorrichtung (60) umfasst außerdem:

   - einen Schaltkreis (72) der Kondensatorklemmen; der Schaltkreis (72) enthält dabei:

   o einen ersten steuerbaren Schalter (78), verbunden zwischen dem ersten Eingang des operativen Verstärkers (62) und der ersten Klemme des Kondensators (64)
   o einen zweiten steuerbaren Schalter (82), verbunden zwischen dem Ausgang des operativen Verstärkers (62) und der zweiten Klemme des Kondensators (64);

o einen dritten steuerbaren Schalter (88), verbunden zwischen dem ersten Eingang des operativen Verstärkers (62) und der zweiten Klemme des Kondensators (64); und

o einen vierten steuerbaren Schalter (90), verbunden zwischen dem Ausgang des operativen Verstärkers (62) und der ersten Klemme des Kondensators (64),

o der erste und der zweite steuerbare Schalter (78, 82) werden durch ein erstes binäres Steuersignal *HDinv* gesteuert;

o der dritte und vierte steuerbare Schalter (88, 90) werden durch ein zweites binäres Steuersignal $\overline{HDinv}$

gesteuert, das zweite binäre Signal $\overline{HDinv}$ bildet eine Ergänzung des ersten binären Signals *HDinv*,

- das Kippen des Signals *HDinv*, und also des Signals $\overline{HDinv}$ , führen zur Umkehrung des Verbindungszustandes des Kondensators (64); und

- einen Auslöseschaltkreis (74) des Schaltkreises (72) mindestens ein Mal während der Integrationsdauer $T_{int}$, wenn die Ausgangsspannung $V_{out}$ des operativen Verstärkers (62) gleichzeitig entsprechend der Variationsrichtung variiert und im Wesentlichen gleich einer Referenzspannung *VREF* ist; und

- einen Speicherschaltkreis (76) zur Speicherung der Anzahl der zwischen dem Anfangsmoment und dem Endmoment der Integrationsdauer aufgetretenen Auslösungen, der Speicherschaltkreis ist dabei mit einem Zähler (96) gekoppelt, der das Steuersignal des Schaltkreises (72) liefert, und dadurch dass

- wenn die erwähnte Variationsrichtung steigt, die erwähnte Referenzspannung *VREF* kleiner oder gleich der hohen Sättigungsspannung $V_{satH}$ ist und die Referenzspannung *VREF* und die Spannung *VBUS* des zweiten Eingangs des operativen Verstärkers (62) so ausgewählt werden, dass die Gleichung 2. $VBUS - VREF \geq V_{satL}$, erfüllt ist; oder

- wenn die erwähnte Variationsrichtung sinkt, die erwähnte Referenzspannung *VREF* höher oder gleich der niedrigen Sättigungsspannung $V_{satL}$ ist und die Referenzspannung *VREF* und die Spannung *VBUS* des zweiten Eingangs des operativen Verstärkers (62) so ausgewählt werden, dass die Gleichung 2. $VBUS - VREF \geq V_{satH}$ erfüllt ist.

2. Vorrichtung (60) zur Integration eines elektrischen Stroms nach Anspruch 1, *dadurch gekennzeichnet, dass* der Auslöseschaltkreis (74) einen Vergleicher (94) enthält, mit einem ersten Eingang verbunden mit dem Ausgang des operativen Verstärkers (62) und mit einem zweiten Eingang, verbunden mit der Referenzspannung *VREF,* der Vergleicher (94) erzeugt dabei eine erste Spannung an einem Ausgang, wenn die Spannung an seinem ersten Eingang kleiner ist, als die Spannung an seinem zweiten Eingang und eine zweite Spannung, verschieden von der ersten Spannung, am Ausgang, wenn die Spannung am ersten Eingang höher ist als die Spannung am zweiten Eingang, so dass eine Bedingung, die zum Auslösen des Schaltkreises (72), umgesetzt durch den Auslöseschaltkreis (74) notwendig ist, erfüllt ist:

- beim Kippen der ersten Spannung zur zweiten Spannung, wenn die erwähnte Variationsrichtung steigt; oder
- beim Kippen der zweiten Spannung zur ersten Spannung, wenn diese Variationsrichtung sinkt.

3. Vorrichtung (60) zur Integration eines elektrischen Stroms nach einem der vorangehenden Ansprüche, *dadurch gekennzeichnet, dass* das Auslösen des Schaltens des Kondensators (64), umgesetzt durch einen Auslöseschaltkreis (74) darin besteht,:

- dass sowohl eine erste Unterbedingung erfüllt wird, die darin besteht, dass die Ausgangsspannung $V_{out}$ des operativen Verstärkers (62) entsprechend der erwähnten Variationsrichtung variiert und im Wesentlichen gleich der Referenzspannung *VREF* ist; als auch
- eine zweite Unterbedingung, die darin besteht, dass die Zahl der Fälle, in denen die erste Unterbedingung erfüllt wurde, seit dem Anfangsmoment der Integrationsdauer $T_{int}$ kleiner ist als eine vorher festgelegte Höchstzahl.

4. Vorrichtung (60) zur Integration eines elektrischen Stroms nach Anspruch 3, **dadurch gekennzeichnet, dass** der Zähler im Auslöseschaltkreis (74) enthalten ist, bei diesem Zähler handelt es sich um einen binären n- Bit- Zähler (96) mit einem Zählereingang, verbunden mit dem Vergleicherausgang (94) und einem Ausgang, der die Zahl der Fälle, seit dem Ausgangsmoment der Integrationsdauer $T_{int}$ angibt, in denen der Ausgang des Vergleichers (94) von der ersten Spannung in die zweite Spannung gekippt ist, wenn die erwähnte Variationsrichtung steigt oder von der zweiten Spannung in die erste Spannung gekippt ist, wenn die erwähnte Variationsrichtung sinkt.

**5.** Vorrichtung (60) zur Integration eines elektrischen Stroms nach dem vorangehenden Anspruch, *dadurch gekennzeichnet, dass* der Auslöseschaltkreis (74) einen Signalgenerator (92) enthält, verbunden mit dem Ausgang des binären Zählers (94), der das erste und zweite binäre Steuersignal *HDinv,* $\overline{HDinv}$ der Schalter (78, 82, 88, 90) kippt, wenn der Ausgang des binären Zählers (94) inkrementiert wird.

**6.** Erkennungssystem für elektromagnetischer Strahlung, die umfasst

- ein Erkennungselement (14, 22), das an einer Ausgangsklemme (S) einen elektrischen Strom, in Abhängigkeit von der elektromagnetischen Strahlung erzeugt; und
- eine Vorrichtung (60) nach irgendeinem der vorangehenden Ansprüche, wobei der erste Eingang des operativen Verstärkers (62) verbunden ist mit der Klemme (S) des Ausgangs des Erkennungselementes (14, 22) zur Integration des vom Erkennungselement erzeugten Stroms.

**7.** Erkennungssystem für elektromagnetischer Strahlung nach Anspruch 6, **dadurch gekennzeichnet, dass** das Erkennungselement umfasst

- einen Erkennungszweig (14), mit einem Erkennungsbolometer (16), bei dem eine Membran über einem Substrat und einem Polarisationsschaltkreis (18) gespannt ist, um die Spannung an den Klemmen des Erkennungsbolometers (16) entsprechend einem Spannungsnennwert zu steuern.
- einen Kompensationszweig (22), mit einem Kompensationsbolometer (24), der im Wesentlichen auf die Substrattemperatur gebracht wurde sowie einem Polarisationsschaltkreis (26) um die Spannung an den Klemmen des Kompensationsbolometers (24) entsprechend einem Spannungsnennwert zu steuern.; und
- Mittel um die Differenz zwischen dem Strom $i_{ac}$, der durch den Erkennungsbolometer (16) fließt und dem Strom $i_{cm}$, der durch den Kompensationsbolometer (24) fließt, zu bilden, so dass der zu integrierende elektrische Strom gebildet wird.

**8.** Verfahren zur Integration eines elektrischen Stroms während einer vorher festgelegten Integrationsdauer $T_{int}$ in einem Kondensator (64) mit zwei Klemmen, verbunden zwischen einem ersten Eingang und dem Ausgang eines operativen Verstärkers (62), mittels einer Vorrichtung (60) nach einem der Ansprüche 1 bis 5, wobei der operative Verstärker einen zweiten Eingang enthält, der auf eine konstante Spannung *VBUS* gebracht wird, die Spannung $V_{out}$ am Ausgang des operativen Verstärkers (62) verändert sich dabei in gleichmäßiger Art und Weise nach einer Variationsrichtung, die entsprechend einer Menge elektrischer Ladungen mit vorher festgelegter Polarität, die im Kondensator (64) gespeichert sind, vorher festgelegt ist, die erwähnte Spannung $V_{out}$ am Ausgang des operativen Verstärkers (62) ist bei einer hohen Sättigungsspannung $V_{satH}$ gesättigt, wenn die Menge der im Kondensator (64) gespeicherten Ladungen der erwähnten Polarität höher ist, als ein vorher festgelegter Grenzwert und die Spannung $V_{out}$ am Ausgang des operativen Verstärkers (62) ist bei einer niedrigen Sättigungsspannung $V_{satL}$ gesättigt, wenn die Menge der im Kondensator (64) gespeicherten Ladungen der erwähnten Polarität niedriger ist, als ein vorher festgelegter Grenzwert; das Verfahren umfasst dabei die folgenden Schritte:

a) vor dem Anfangsmoment der Integrationsdauer $T_{int}$, Initialisierung auf Null der Ladung des Kondensators (64) und eines Zählerwertes;
b) während der Integrationsdauer $T_{int}$ Integration des elektrischen Stroms in den Kondensator (64);
c) Schaltung der Klemmen des Kondensators mindestes ein Mal während der Integrationsdauer $T_{int,}$, wenn die Ausgangsspannung des operativen Verstärkers (62) entsprechend dieser Variationsrichtung variiert und gleichzeitig gleich einer vorher festgelegten Referenzspannung *VREF* ist

∘ wenn die erwähnte Variationsrichtung steigt, ist die erwähnte Referenzspannung *VREF* kleiner oder gleich der hohen Sättigungsspannung $V_{satH}$ und die Referenzspannung *VREF* und die Spannung *VBUS* des zweiten Eingangs des operativen Verstärkers (62) werden so ausgewählt, dass die Gleichung 2. *VBUS* - *VREF* $\geq V_{satL}$ erfüllt ist; oder
o wenn die erwähnte Variationsrichtung steigt, ist die erwähnte Referenzspannung *VREF* kleiner oder gleich der hohen Sättigungsspannung $V_{satH}$, und die Referenzspannung *VREF* und die Spannung *VBUS* des zweiten Eingangs des operativen Verstärkers (62) werden so ausgewählt, dass die Gleichung 2. *VBUS* - *VREF* $\geq V_{satH}$ erfüllt ist.;

d) Inkrementierung einer Einheit des Zählerwertes infolge jedes Schaltens des Kondensators (64) während der

Integrationsdauer $T_{int}$ und
e) nach dem Abschlussmoment der Integrationsdauer $T_{int}$, Ausgabe des Zählerwertes.

**Claims**

1. A device (60) for integrating an electric current received on an integration node for a period of predetermined duration $T_{int}$, comprising an operational amplifier (62) having a first and a second input and an output, and a capacitor (64) having two terminals adapted to be connected between the first input and the output of the operational amplifier (62), the second input of the amplifier being taken to a constant voltage *VBUS,* the first input of the amplifier being connected to the integration node, and the output terminal of the operational amplifier supplying an output voltage $V_{out}$ which varies monotonously in a predetermined variation direction according to a quantity of electric charges of predetermined polarity stored in the capacitor (64), output voltage $V_{out}$ of the operational amplifier (62) being saturated at a high saturation voltage $V_{satH}$ when the quantity of electric charges of said polarity stored in the capacitor (64) is greater than a predetermined threshold, and output voltage $V_{out}$ of the operational amplifier (62) being saturated at a low saturation voltage $V_{satL}$ when the quantity of electric charges of said polarity stored in the capacitor (64) is smaller than a predetermined threshold,
   the device (60) further comprising:

   - a circuit (72) for switching the capacitor terminals, said switching circuit (72) comprising :

      • a first controllable switch (78) connected between the first input of the operational amplifier (62) and the first terminal of the capacitor (64);
      • a second controllable switch (82) connected between the output of the operational amplifier (62) and the second terminal of the capacitor (64);
      • a third controllable switch (88) connected between the first input of the operational amplifier (62) and the second terminal of the capacitor (64);
      • a fourth controllable switch (90) connected between the output of the operational amplifier (62) and the first terminal of the capacitor (62),

   the first and the second controllable switches (78, 82) being controlled by a first binary control signal *HDinv;*
   the third and the fourth controllable switches (88, 90) are controlled by a second binary control signal $\overline{HDinv}$, the second binary signal $\overline{HDinv}$ being the complement of first binary signal *HDinv ;*
   the switching of signal *HDinv,* and thus of signal $\overline{HDinv}$, causing the inversion of the connection state of capacitor (64),
   - a circuit (74) for triggering the switching circuit (72) at least once during integration period $T_{int}$ when output voltage $V_{out}$ of the operational amplifier (62) both varies in said variation direction and is substantially equal to a reference voltage *VREF*; and
   - a storage circuit (76) for storing the number of triggerings having occurred between the initial time and the end time of the integration period, said storage circuit (76) being coupled to a counter (96) providing the command signal of the switching circuit (72) ;

   wherein:

   - when said variation direction is increasing, said reference voltage *VREF* is smaller than or equal to high saturation voltage $V_{satH}$, and reference voltage *VREF* and voltage *VBUS* of the second input of the operational amplifier (62) are selected to comply with relation 2. *VBUS - VREF* $\geq V_{satL}$; or
   - when said variation direction is decreasing, said reference voltage *VREF* is greater than or equal to low saturation voltage $V_{satL}$, and reference voltage *VREF* and voltage *VBUS* of the second input of the operational amplifier (62) are selected to comply with relation 2. *VBUS - VREF* $\leq V_{satH}$.

2. The electric current integration device of claim 1, **characterized** in that the triggering circuit (74) comprises a comparator (94) having a first input connected to the output of the operational amplifier (62) and a second input connected to the reference voltage *VREF,* the comparator (94) generating a first voltage on an output when the voltage on its first input is lower than the voltage on its second input, and generating a second voltage, different from the first voltage, on the output when the voltage on its first input is greater than the voltage on its second input, so that a condition necessary for the triggering of the switching circuit (72) implemented by the triggering circuit (74) is fulfilled:

- on switching from the first voltage to the second voltage if said variation direction is increasing; or
- on switching from the second voltage to the first voltage if said variation direction is decreasing.

3. The electric current integration device of any of the foregoing claims, **characterized in that** the triggering of the switching of the capacitor (64) implemented by the triggering circuit (74) comprises fulfilling at the same time:

- a first sub-condition according to which output voltage $V_{out}$ of the operational amplifier (62) varies in said variation direction and is substantially equal to the reference voltage VREF; and
- a second sub-condition according to which the number of times when the first subcondition has been fulfilled from the initial time of integration period $T_{int}$ is shorter than a predetermined maximum number.

4. The electric current integration device of claim 3, **characterized in that** the counter is comprised in the triggering circuit (74), said counter being a binary counter over n bits (96) having a counting input connected to the output of the comparator (94) and an output supplying the number of times from the initial time of integration period Tint where the output of the comparator (94) switches from the first voltage to the second voltage when said variation direction is increasing or switches from the second voltage to the first voltage when said variation direction is decreasing.

5. The electric current integration device of the preceding claim, **characterized in that** the triggering circuit (74) comprises a signal generator (92) connected to the output of the binary counter (94) and switching the first and second binary control signals HDinv, $\overline{HDinv}$ of the switches (78, 82, 88, 90) when the output of the binary counter (94) is incremented.

6. An electromagnetic radiation detection system comprising:

- a detection element (14, 22) generating on an output terminal (S) an electric current according to the electromagnetic radiation; and
- the device (60) of any of the foregoing claims, the first input of the operational amplifier (62) being connected to the output terminal (S) of the detection element (14, 22) for the integration of the current generated by the detection element.

7. The electromagnetic radiation detection system of claim 6, **characterized in that** the detection element comprises:

- a detection branch (14), comprising a detection bolometer (16) having a membrane suspended above a substrate and a bias circuit (18) for setting the voltage across the detection bolometer (16) according to a voltage set point;
- a compensation branch (22) comprising a compensation bolometer (24) substantially taken to the substrate temperature, and a bias circuit (26) for setting the voltage across the compensation bolometer (24) according to a voltage set point; and
- and means for forming the difference between current $i_{ac}$ running through the detection bolometer (16) and current $i_{cm}$ running through the compensation bolometer (24) to form the electric current to be integrated.

8. A method of integrating an electric current during a predetermined integration duration $T_{int}$ in a capacitor (64) having two terminals connected between a first input and the output of an operational amplifier (62), the operational amplifier comprising a second input taken to a constant voltage VBUS, output voltage $V_{out}$ of the operational amplifier (62) varying monotonously in a predetermined variation direction according to a quantity of electric charges of predetermined polarity stored in the capacitor (64), said output voltage $V_{out}$ being saturated at a high saturation voltage $V_{satH}$ when the quantity of electric charges stored in the capacitor (64) is greater than a predetermined threshold, and output voltage $V_{out}$ of the operational amplifier (62) being saturated at a low saturation voltage $V_{satL}$ when the quantity of electric charges of said polarity stored in the capacitor (64) is smaller than a predetermined threshold, the method comprising the steps of:

a) before the initial time of integration period $T_{int}$, initializing to zero the capacitor charge (64) and a counting value;
b) integrating during integration period $T_{int}$ the electric current in the capacitor (64);
c) switching the capacitor terminals at least once during integration period $T_{int}$ when the output voltage of the operational amplifier (62) both varies in said variation direction and is equal to a predetermined reference voltage VREF,

- when said variation direction is increasing, said reference voltage VREF being smaller than or equal to high saturation voltage $V_{satH}$, and reference voltage *VREF* and voltage *VBUS* of the second input of the operational amplifier (62) are selected to comply with relation 2. $VBUS - VREF \geq V_{satL}$; or

▪ when said variation direction is decreasing, said reference voltage *VREF* being greater than or equal to low saturation voltage $V_{satL}$, and reference voltage *VREF* and voltage *VBUS* of the second input of the operational amplifier (62) are selected to comply with relation 2. $VBUS - VREF \leq V_{satH}$.

d) incrementing by one the counting value after each switching of the capacitor (64) during integration period $T_{int}$; and

e) after the end time of integration period $T_{int}$, supplying the counting value.

PIXEL DE COMPENSATION

22

VSK

24

Vcm

520

GCM

B

26

S

CTIA

28

Reset

34

32

S

−

+

VOUT

VBUS

30

PIXEL DE DETECTION

10

14

S

Select

20

GAC

18

530

A

IR

Vac

16

VDET

12

42

14

22

28

36

38

40

VIDEO

**Fig. 1**

(Etat de la technique)

# Fig. 2

(Etat de la technique)

**Fig. 3**

EP 3 140 906 B1

Basculement de SCOMP

Valeur échantillonnée
dynamique étendue

Vout

Zone de saturation

VREF

VBUS

2VBUS-VREF

**Fig. 4A**

t

RAZ

**Fig. 4B**

Tint

t

FSH

**Fig. 4C**

t

Ⓐ    Ⓑ    Ⓐ    Ⓑ

Ⓑ1    Ⓑ2    Ⓑ3    Ⓑ1

Signal VIDEO
en sortie amplificateur 40

Pixels ayant déclenché le dispositif de
dynamique étendue

| Pixi | Pixi+1 | Pixi+2 | Pixi+3 | Pixi+4 | Pixi+5 | Pixi+6 | Pixi+7 | Pixi+8 | Pixi+9 | |

t

# Fig. 5A

Signaux
HD $_{SH}$[2:0]
En sortie

| | | 000 | | 010 | 000 | | 011 | | 000 |

t

# Fig. 5B

## RÉFÉRENCES CITÉES DANS LA DESCRIPTION

*Cette liste de références citées par le demandeur vise uniquement à aider le lecteur et ne fait pas partie du document de brevet européen. Même si le plus grand soin a été accordé à sa conception, des erreurs ou des omissions ne peuvent être exclues et l'OEB décline toute responsabilité à cet égard.*

**Documents brevets cités dans la description**

- WO 2007135175 A
- US 7202463 B
- JP H02264421 B

**Littérature non-brevet citée dans la description**

- Uncooled amorphous silicon technology enhancement for $25\mu$m pixel pitch achievement. **E. MOTTIN et al.** Infrared Technology and Application XXVIII. SPIE, vol. 4820E
- *Proc. of SPIE,* 2008, vol. 6940, 694020
- *Proc. of SPIE,* 2007, vol. 6542, 65421R
- *IEEE journal of solid-state circuits,* Juin 1985, vol. sc-20 (3